# EUROPEAN PATENT APPLICATION

(11) **EP 4 156 287 A1**
(43) Date of publication of application: **29.03.2023**
(21) Application number: 22184387.3
(22) Date of filing: 12.07.2022
(51) Int. Cl.: H01L 29/417, H01L 29/786, H01L 27/12

(54) **THIN-FILM TRANSISTORS WITH SHARED CONTACTS**

(30) Priority: 17.09.2021 US 202117477850
(71) Applicant: INTEL Corporation, Santa Clara, CA 95054 (US)
(72) Inventor: Sharma, Abhishek A., Hillsboro, 97124 (US); Sato, Noriyuki, Hillsboro, 97124 (US); Le, Van H., Beaverton, 97007 (US); Atanasov, Sarah, Beaverton, 97003 (US); Hui Jae, Yoo, Hillsboro, 97124 (US)
(74) Representative: Goddar, Heinz J.

(57) **Abstract**

Integrated circuit (IC) devices implementing pairs of thin-film transistors (TFTs) with shared contacts, and associated systems and methods, are disclosed. An example IC device may include a support structure, a channel layer provided over the support structure, where the channel layer includes a thin-film semiconductor material, a first TFT with a channel region that includes a first portion of the channel layer, and a second TFT with a channel region that includes a second portion of the channel layer. In some embodiments, a source or a drain (S/D) contact of the first TFT may be a shared contact that is also a S/D contact of the second TFT. In other embodiments, a gate contact/stack of the first TFT may be a shared contact/stack that is also a gate contact/stack of the second TFT.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1-8 provide cross-sectional side views illustrating different examples of integrated circuit (IC) devices with two top-gated thin-film transistors (TFTs) sharing a source/drain (S/D) contact, according to some embodiments of the present disclosure.
FIGS. 9-16 provide cross-sectional side views illustrating different examples of IC devices with two bottom-gated TFTs sharing a source/drain contact, according to some embodiments of the present disclosure.
FIGS. 17-18 provide cross-sectional side views illustrating different examples of IC devices with two vertical TFTs sharing a gate contact, according to some embodiments of the present disclosure.
FIGS. 19A-19B are top views of a wafer and dies that may include one or more pairs of TFTs with shared contacts, according to some embodiments of the present disclosure.
FIG. 20 is a cross-sectional side view of an IC device that may include one or more pairs of TFTs with shared contacts, according to some embodiments of the present disclosure.
FIG. 21 is a cross-sectional side view of an IC package that may include one or more IC devices implementing pairs of TFTs with shared contacts, according to some embodiments of the present disclosure.
FIG. 22 is a cross-sectional side view of an IC device assembly that may include one or more IC devices implementing pairs of TFTs with shared contacts, according to some embodiments of the present disclosure.
FIG. 23 is a block diagram of an example computing device that may include one or more IC devices implementing pairs of TFTs with shared contacts, according to some embodiments of the present disclosure.

### Detailed Description

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC devices and assemblies implementing pairs of TFTs with shared contacts as described herein, it might be useful to first understand phenomena that may come into play in certain IC arrangements. The following foundational information may be viewed as a basis from which the present disclosure may be properly explained. Such information is offered for purposes of explanation only and, accordingly, should not be construed in any way to limit the broad scope of the present disclosure and its potential applications.

A TFT is a special kind of a field-effect transistor (FET) made by depositing a thin film of an active semiconductor material, as well as providing a gate stack and metallic contacts, over a supporting layer that may be a non-conducting layer. At least a portion of the active semiconductor material forms a channel region of the TFT. This is different from conventional, non-TFT, frontend transistors where the active semiconductor channel material is typically a part of a semiconductor substrate, e.g., a part of a silicon wafer. TFTs provide several advantages and enables unique architectures that were not possible with conventional, frontend transistors, and may be used in a large variety of applications, e.g., as access transistors of memory cells. One advantage is that a TFT may have substantially lower leakage than a frontend transistor. Another advantage is that a TFT may easily be integrated in the backend of an IC device.

IC devices implementing pairs of TFTs with shared contacts, and associated systems and methods, are disclosed. An example IC device may include a support structure (e.g., a substrate, a wafer, a die, or a chip), a channel layer provided over the support structure, where the channel layer includes a thin-film semiconductor material, a first TFT with a channel region that includes a first portion of the channel layer, and a second TFT with a channel region that includes a second portion of the channel layer. In some embodiments, a S/D contact of the first TFT may be a shared contact that is also a S/D contact of the second TFT. In other embodiments, a gate contact/stack of the first TFT may be a shared contact/stack that is also a gate contact/stack of the second TFT. Implementing pairs of TFTs with shared contacts as described herein (i.e., implementing pairs of TFTs that either share a S/D contact or a gate contact) may allow significantly increasing density of TFTs in an array having a given footprint area (the footprint area being defined as an area in a plane of the support structure, or a plane parallel to the plane of the support structure), or, conversely, allows significantly reducing the footprint area of the array with a given TFT density.

In the following, some descriptions may refer to a particular S/D region or contact being either a source region/contact or a drain region/contact. However, unless specified otherwise, which region/contact of a transistor is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

In the following detailed description, various aspects of the illustrative implementations will be described using terms commonly employed by those skilled in the art to convey the substance of their work to others skilled in the art. For example, a term "interconnect" may be used to describe any interconnect structure formed of an electrically conductive material for providing electrical connectivity to one or more components associated with an IC or/and between various such components. In general, the term "interconnect" may refer to both conductive lines (or, simply, "lines," also sometimes referred to as "traces" or "trenches") and conductive vias (or, simply, "vias"). In general, in context of interconnects, the term "conductive line" may be used to describe an electrically conductive element isolated by an insulator material (e.g., a low-k dielectric material) that is provided within the plane of an IC die. Such conductive lines are typically stacked into several levels, or several layers, of a metallization stack. On the other hand, the term "conductive via" may be used to describe an electrically conductive element that interconnects two or more conductive lines of different levels. To that end, a conductive via may be provided substantially perpendicularly to the plane of an IC die and may interconnect two conductive lines in adjacent levels or two conductive lines in not adjacent levels. A term "metallization stack" may be used to refer to a stack of one or more interconnects for providing connectivity to different circuit components of an IC chip. Sometimes, conductive lines and vias may be referred to as "metal lines" and "metal vias", respectively, to highlight the fact that these elements include electrically conductive materials such as metals.

In another example, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple sub-elements. For example, "an electrically conductive material" may include one or more electrically conductive materials. If used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function. The terms "substantially," "close," "approximately," "near," and "about," generally refer to being within +/- 20% of a target value (e.g., within +/-10% or within +/-5% of a target value) based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

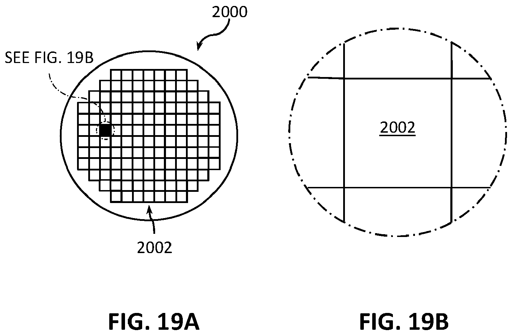

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 19A-19B, such a collection may be referred to herein without the letters, e.g., as "FIG. 19." In order to not clutter the drawings, sometimes only one instance of a given element is labeled in a drawing with a reference numeral, although other similar elements may be shown.

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of TFTs with shared contacts), this is simply for ease of illustration, and more, or less, than that number may be included in the IC devices and related assemblies and packages according to various embodiments of the present disclosure. Still further, various views shown in some of the drawings are intended to show relative arrangements of various elements therein. In other embodiments, various IC devices and related assemblies and packages, or portions thereof, may include other elements or components that are not illustrated (e.g., various interconnects or further components that may contact different portions of the TFTs with shared contacts, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., physical failure analysis (PFA) would allow determination of presence of one or more IC devices implementing pairs of TFTs with shared contacts as described herein.

Various IC devices implementing pairs of TFTs with shared contacts as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

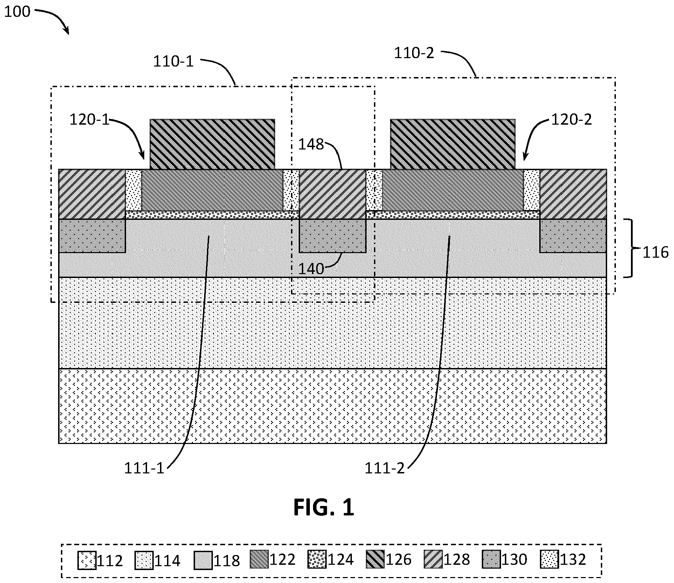

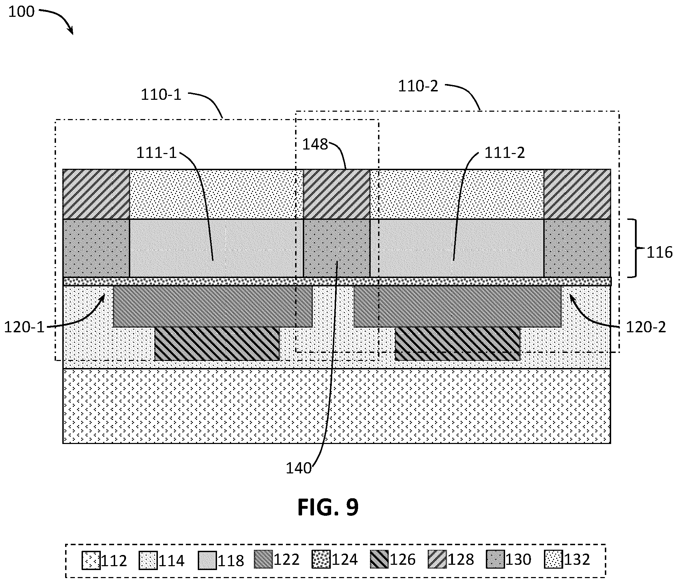

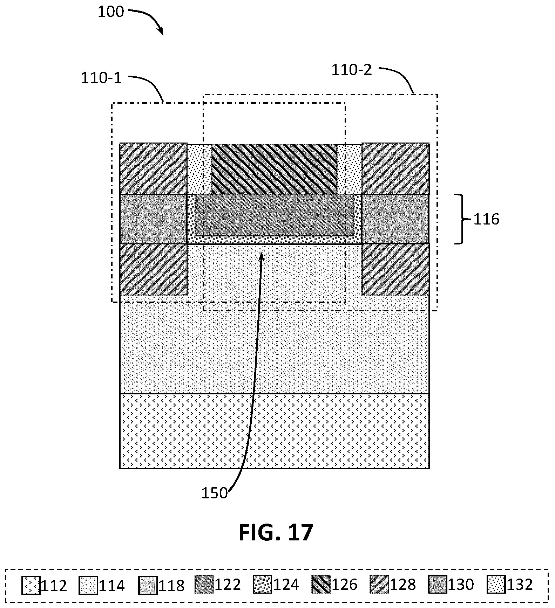

In general, any of TFTs with shared contacts as described herein may be top-gated TFTs, bottom-gated TFTs, or vertical TFTs. A pair of top-gated and/or bottom-gated TFTs may share a single S/D contact, while a pair of vertical TFTs may share a single gate contact. To that end, FIGS. 1-8 provide cross-sectional side views illustrating different examples of IC devices 100 with two top-gated TFTs sharing a S/D contact, according to some embodiments of the present disclosure; FIGS. 9-16 provide cross-sectional side views illustrating different examples of IC devices 100 with two bottom-gated TFTs sharing a S/D contact, according to some embodiments of the present disclosure; and FIGS. 17-18 provide cross-sectional side views illustrating different examples of IC devices 100 with two vertical TFTs sharing a gate contact, according to some embodiments of the present disclosure. A number of elements labeled in FIGS. 1-18 with reference numerals are indicated in FIGS. 1-18 with different patterns in order to not clutter the drawings with too many reference numerals, with a legend showing the correspondence between the reference numerals and patterns being provided at the bottom of FIGS. 1-18. For example, the legend illustrates that FIGS. 1-18 use different patterns to show a support structure 112, S/D contacts 128, gate contacts 126, etc. Individual transistors of a pair of TFTs sharing a contact are labeled in FIGS. 1-18 as TFTs 110-1 and 110-2, where dash-dotted contours are shown to illustrate approximate boundaries of these transistors.

FIGS. 1-8 provide cross-sectional side views illustrating different examples of IC devices 100 with two top-gated TFTs 110-1 and 110-2 sharing a S/D contact, according to some embodiments of the present disclosure.

As shown in FIG. 1, the TFTs 110 may be provided over a support structure 112. In particular, in some embodiments, an intermediate layer 114 may be provided over the support structure 112, and then a layer 116 of a thin-film semiconductor material 118 that will serve as a basis for channel regions 111 of the TFTs 110 (hence, the layer 116 may be referred to as a "channel layer 116") may be provided over the intermediate layer 114.

In general, implementations of the present disclosure may be formed or carried out on a substrate, such as a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the substrate may be a printed circuit board (PCB) substrate. Although a few examples of materials from which the substrate may be formed are described here, any material that may serve as a foundation upon which the TFTs 110 with shared contacts as described herein may be built falls within the spirit and scope of the present disclosure.

The intermediate layer 114 may be a frontend layer, e.g., a layer with a plurality of frontend devices, e.g., frontend transistors, such as FinFETs, nanosheet transistors, nanoribbon transistors, nanowire transistors, or planar transistors. In some embodiments, the intermediate layer 114 may also include one or more backend layers, e.g., one or more backend memory layers. Details of the intermediate layer 114 are not shown because various manners for arranging various devices and interconnects are known in the art, all of which being within the scope of the present disclosure.

The layer 116 may include a thin-film semiconductor material 118. The layer 116 may be in the backend of the IC device 100 because thin-film semiconductor materials may be deposited at relatively low temperatures, compared to the relatively high temperatures required for epitaxially growing single-crystalline semiconductor materials of the semiconductor materials used for frontend devices. Whether a semiconductor channel material of a given transistor is a thin-film channel material or a single-crystalline semiconductor material may be identified by inspecting the grain size of the material. An average grain size of a semiconductor material in a channel region of a transistor being between about 0.05 and 1 millimeters (in which case the material may be considered to be polycrystalline) or smaller than about 0.05 millimeter (in which case the material may be considered to be polymorphous) may be indicative of the semiconductor material having been deposited at the relatively low temperatures (i.e., indicative of the transistor being a TFT). On the other hand, an average grain size of the semiconductor material being equal to or greater than about 1 millimeter (in which case the material may be considered to be a substantially single-crystalline material) may be indicative of the semiconductor material having been epitaxially grown (which, in general, is a process performed at substantially higher temperatures than those at which thin-film semiconductor materials may be deposited for TFTs).

For any of the TFTs 110 described herein, a channel region 111 of the thin-film semiconductor material 118 may be composed of semiconductor material systems including, for example, N-type or P-type materials systems. In some embodiments, the channel region 111 of a TFT 110 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the channel region 111 of a TFT 110 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In particular, the channel region of a TFT may be a thin-film material. Some such materials may be deposited at relatively low temperatures, which allows depositing them within the thermal budgets imposed on back end fabrication to avoid damaging the frontend components (e.g., components included in the intermediate layer 114). In some embodiments, the channel region 111 of a TFT 110 may have a thickness between about 5 and 75 nanometers, including all values and ranges therein.

As shown in FIG. 1, each of the TFTs 110 may include a gate stack 120 that may include a gate electrode material 122 and, optionally, a gate dielectric material 124. Each of the transistors may further include a gate contact 126, a pair of S/D contacts 128, and, optionally S/D regions 130. The TFTs 110 shown in FIG. 1 are top-gated TFTs, since their respective channel regions 111 in the thin-film semiconductor material 118 are between the support structure 112 and the respective gate stacks 120. Furthermore, FIG. 1 also illustrates that each of the S/D contacts 128 is provided above the thin-film semiconductor material 118, similar to the gate stacks 120, although in other embodiments, one or more of the S/D contacts 128 may be provided on the bottom face of the layer 116.

In some embodiments, the IC device 100 may further include an insulator material, not specifically shown in FIG. 1, surrounding portions of various components of the IC device 100 to provide electrical isolation between various portions, as needed. Such an insulator material may, e.g., be an interlayer dielectric (ILD) material that may surround various portions of the TFTs 110 and various other components, including various interconnects, implemented in the IC device 100. In various embodiments, such an insulator material may include any suitable ILD materials such as silicon oxide, carbon-doped silicon oxide, silicon carbide, silicon nitride, aluminum oxide, and/or silicon oxynitride. In various embodiments, such an insulator material may include a low-k dielectric material. Examples of the low-k dielectric materials that may be used as the insulator material in the IC device 100 include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the insulator material in the IC device 100 include organic polymers such as polyimide, polynorbornenes, benzocyclobutene, perfluorocyclobutane, or polytetrafluoroethylene (PTFE). Still other examples of low-k dielectric materials that may be used as the insulator material in the IC device 100 include silicon-based polymeric dielectrics such as hydrogen silsesquioxane (HSQ) and methylsilsesquioxane (MSQ). Other examples of low-k materials that may be used in the insulator material in the IC device 100 include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1.

A gate stack 120 including a gate electrode material 122 and, optionally, a gate dielectric material 124, may be provided on or under a portion of the thin-film semiconductor material 118 that forms a channel region of a respective TFT 110. In particular, the gate dielectric material 124 may be provided so that at least a portion of the gate dielectric material 124 is between the gate electrode material 122 and a portion of the thin-film semiconductor material 118 that forms a channel region of a respective TFT 110. The gate electrode material 122 may include at least one P-type work function metal or N-type work function metal, depending on whether the TFT 110 is a PMOS transistor or an NMOS transistor (P-type work function metal used as the gate electrode material 122 when the TFT 110 is a PMOS transistor and N-type work function metal used as the gate electrode material 122 when the TFT 110 is an NMOS transistor). For a PMOS transistor, metals that may be used for the gate electrode material 122 may include, but are not limited to, ruthenium, palladium, platinum, cobalt, nickel, and conductive metal oxides (e.g., ruthenium oxide). For an NMOS transistor, metals that may be used for the gate electrode material 122 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 122 may include a stack of two or more metal layers, where one or more metal layers are work function metal layers and at least one metal layer is a fill metal layer. Further layers may be included next to the gate electrode material 122 for other purposes, such as to act as a diffusion barrier layer or/and an adhesion layer.

In some embodiments, the gate dielectric material 124 may include one or more high-k dielectrics including any of the materials discussed herein with reference to the insulator material that may surround portions of various components in the IC device 100. In some embodiments, an annealing process may be carried out on the gate dielectric material 124 during manufacture of the IC device 100 to improve the quality of the gate dielectric material 124. The gate dielectric material 124 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 120 may be surrounded by a gate spacer 132. The gate spacer 132 could be configured to provide separation between the gate stack 120 and source/drain contacts 128 of the TFTs 110 and could be made of a low-k dielectric material, some examples of which have been provided above. The gate spacer 132 may include pores or air gaps to further reduce its dielectric constant.

As further shown in FIG. 1, the TFTs 110 may include a source region and a drain region on either side of the gate stack 120, thus realizing a transistor. As is well known in the art, source and drain regions are formed for the gate stack of each metal-oxide-semiconductor (MOS) transistor. As described above, the source and drain regions of a transistor are interchangeable, and a nomenclature of a first S/D region and a second S/D region of a transistor may be used to differentiate between different S/D regions of a transistor. The S/D regions 130 of a TFT 110 may generally be formed using either an implantation/diffusion process or an etching/deposition process. In the former process, dopants such as boron, aluminum, antimony, phosphorous, or arsenic may be ion-implanted into the thin-film semiconductor material 118 to form the source and drain regions. An annealing process that activates the dopants and causes them to diffuse further into the thin-film semiconductor material 118 may follow the ion implantation process. In the latter process, portions of the thin-film semiconductor material 118 may first be etched to form recesses at the locations of the future S/D regions 130. An epitaxial deposition process may then be carried out to fill the recesses with material that is used to fabricate the S/D regions 130. In some implementations, the S/D regions 130 may be fabricated using a silicon alloy such as silicon germanium or silicon carbide. In some implementations the epitaxially deposited silicon alloy may be doped in situ with dopants such as boron, arsenic, or phosphorous. In further embodiments, the S/D regions 130 may be formed using one or more alternate semiconductor materials such as germanium or a group III-V material or alloy. And in further embodiments, one or more layers of metal and/or metal alloys may be used to form the S/D regions 130.

For each of the TFTs 110, a respective gate contact 126 may be used to contact the gate electrode material 122 of the gate stack 120, and a respective S/D contact 128 may be used to contact different ones of the S/D regions 130, as shown in FIG. 1. In particular, as shown in FIG. 1, the pair of TFTs 110 may share one of their S/D regions 130, labeled in FIG. 1 as a shared S/D region 140, and, consequently, the TFTs 110 may also share the S/D contact 132 coupled to the shared S/D region 140, the shared S/D contact labeled in FIG. 1 as a shared S/D contact 148. In other embodiments, what is shown in FIG. 1 as S/D regions 130 may be undoped regions of the thin-film semiconductor material 118.

Each of the gate contact 126 and the S/D contacts 128, as well as various interconnects that may be included in the IC device 100 may be formed of any suitable electrically conductive material, which may include an alloy or a stack of multiple electrically conductive materials. In some embodiments, such electrically conductive materials may include one or more metals or metal alloys, with metals such as copper, ruthenium, palladium, platinum, cobalt, nickel, hafnium, zirconium, titanium, tantalum, and aluminum. In some embodiments, such electrically conductive materials may include one or more electrically conductive alloys oxides or carbides of one or more metals.

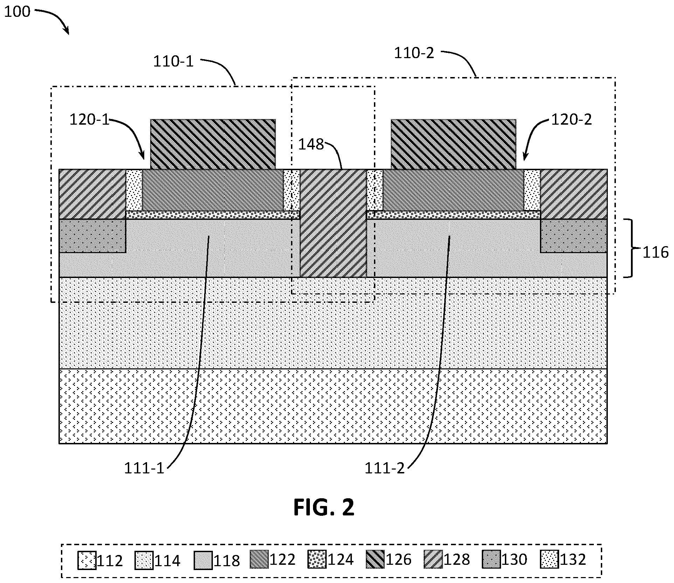

In the IC device 100 shown in FIG. 1, the shared S/D contact 148 contacts a portion of the top surface of the thin-film semiconductor material 118 (i.e., the shared S/D contact 148 is a front-side shared S/D contact 148). FIG. 2 illustrates an embodiment of the IC device 100 that is substantially the same as that shown in FIG. 1 (i.e., top-gated TFTs 110, front-side shared S/D contact 148), except that the shared S/D contact 148 extends all through the thin-film semiconductor material 118, towards the support structure 110. Having the shared S/D contact 148 extend through the thin-film semiconductor material 118 may provide the advantage of a clear separation between the channel region 111-1 of the first TFT 110-1 and the channel region 111-2 of the second TFT 110-2. In further embodiments of the top-gated TFTs 110 with front-side shared S/D contact 148, the shared S/D contact 148 may extend partially into the thin-film semiconductor material 118, i.e., it may extend below contacting the top surface of the thin-film semiconductor material 118 as shown in FIG. 1, but not all the way through the thin-film semiconductor material 118 as shown in FIG. 2.

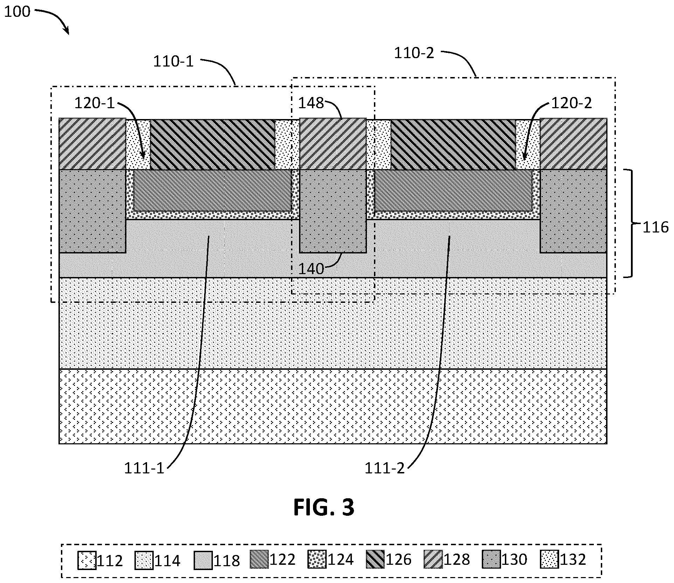

In the IC devices 100 shown in FIG. 1 and FIG. 2, the gate stacks 120 are provided above respective portions of the top surface of the thin-film semiconductor material 118. In such embodiments, the bottoms of the gate stacks 120 may be aligned with the bottoms of the S/D contacts 128 because both the gate stacks 120 and the S/D contacts 128 contact respective portions of the thin-film semiconductor material 118. FIG. 3 illustrates an embodiment of the IC device 100 that is substantially the same as that shown in FIG. 1 (i.e., top-gated TFTs 110, front-side shared S/D contact 148), except that the layer 116 is shown to be thicker so that it is easier to illustrate that the gate stacks 120 are recessed into the thin-film semiconductor material 118. For example, in some embodiments, the tops of the gate stacks 120 may be aligned with the top of the thin-film semiconductor material 118 and with the bottom of the S/D contacts 128, as shown in FIG. 3. However, in other embodiments of the recessed gate stacks 120 with top-gated TFTs 110 and front-side shared S/D contact 148, the gate stacks 120 may be only partially recessed into the thin-film semiconductor material 118, i.e., with portions of sidewalls of the gate stacks 120 being in the layer 116, while other portions of sidewalls of the gate stacks 120 being above the layer 116. Recessing the gate stacks 120 of the top-gated TFTs 110 into the thin-film semiconductor material 118 may have the advantage of an increased gate length for the same surface area occupied by a gate stack.

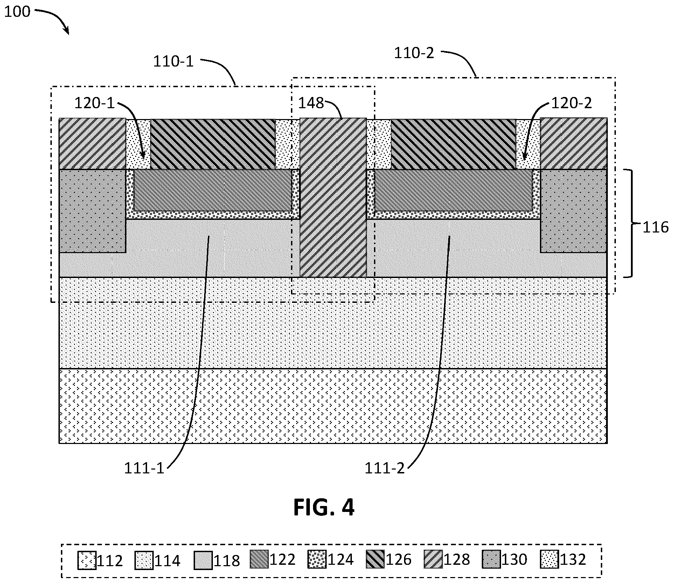

In the IC device 100 shown in FIG. 3, the shared S/D contact 148 contacts a portion of the top surface of the thin-film semiconductor material 118. FIG. 4 illustrates an embodiment of the IC device 100 that is substantially the same as that shown in FIG. 3 (i.e., top-gated TFTs 110, front-side shared S/D contact 148, recessed gate stacks 120), except that the shared S/D contact 148 extends all through the thin-film semiconductor material 118, towards the support structure 110, which may have advantages as described above. In further embodiments of the top-gated TFTs 110 with front-side shared S/D contact 148 and recessed gate stacks 120, the shared S/D contact 148 may extend partially into the thin-film semiconductor material 118, i.e., it may extend below contacting the top surface of the thin-film semiconductor material 118 as shown in FIG. 3, but not all the way through the thin-film semiconductor material 118 as shown in FIG. 4.

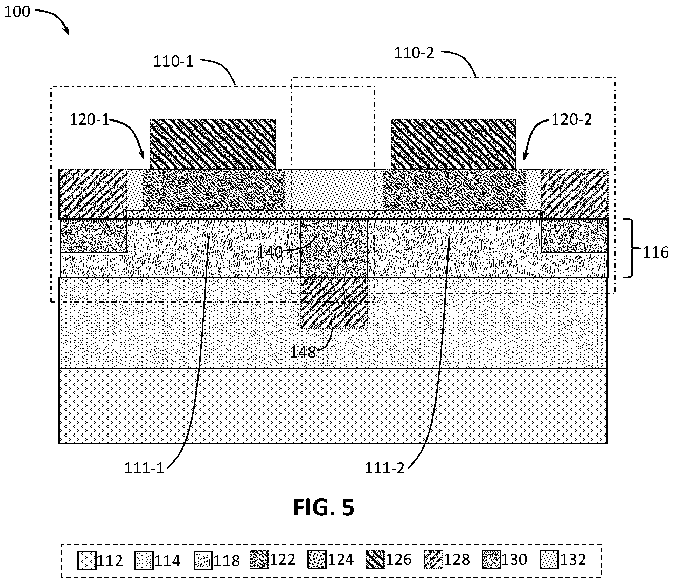

In the IC device 100 shown in FIGS. 1-4, the shared S/D contact 148 is a front-side contact in that it is provided from the top of the layer 116. FIG. 5 illustrates an embodiment of the IC device 100 that is substantially the same as that shown in FIG. 1 (i.e., top-gated TFTs 110), except that the shared S/D contact 148 is provided at the bottom of the layer 116 (i.e., the shared S/D contact 148 is a backside shared S/D contact 148). Having the shared S/D contact 148 at the bottom of the TFTs 110 may provide the advantage of easier connection of the shared S/D contact 148 to other IC device components underneath the TFTs 110 (e.g., to the frontend transistors of the IC device 100 or to backside power delivery structures that may be present in the IC device 100). It may also provide the advantage of less crowded space above the TFTs 110.

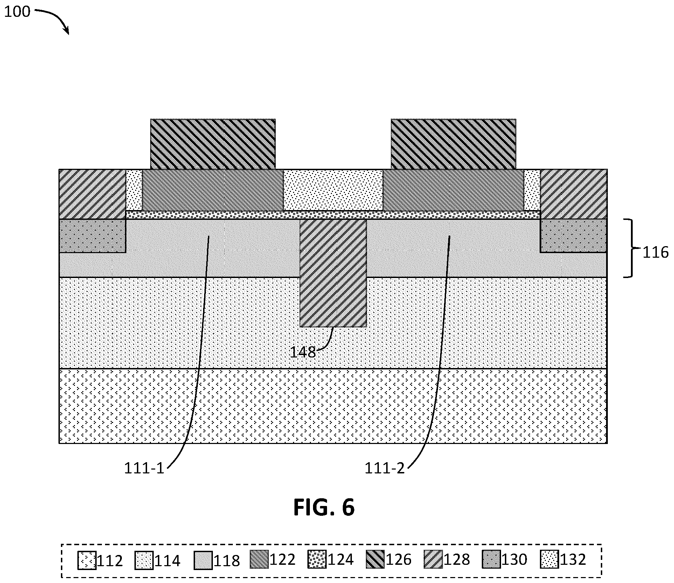

In the IC device 100 shown in FIG. 5, the shared S/D contact 148 contacts a portion of the bottom surface of the thin-film semiconductor material 118. FIG. 6 illustrates an embodiment of the IC device 100 that is substantially the same as that shown in FIG. 5 (i.e., top-gated TFTs 110, backside shared S/D contact 148), except that the shared S/D contact 148 extends all through the thin-film semiconductor material 118, from the bottom of the layer 116 and away from the support structure 110, which may have advantages as described above. In further embodiments of the top-gated TFTs 110 with backside shared S/D contact 148, the shared S/D contact 148 may extend partially into the thin-film semiconductor material 118, i.e., it may extend above contacting the bottom surface of the thin-film semiconductor material 118 as shown in FIG. 5, but not all the way through the thin-film semiconductor material 118 as shown in FIG. 6.

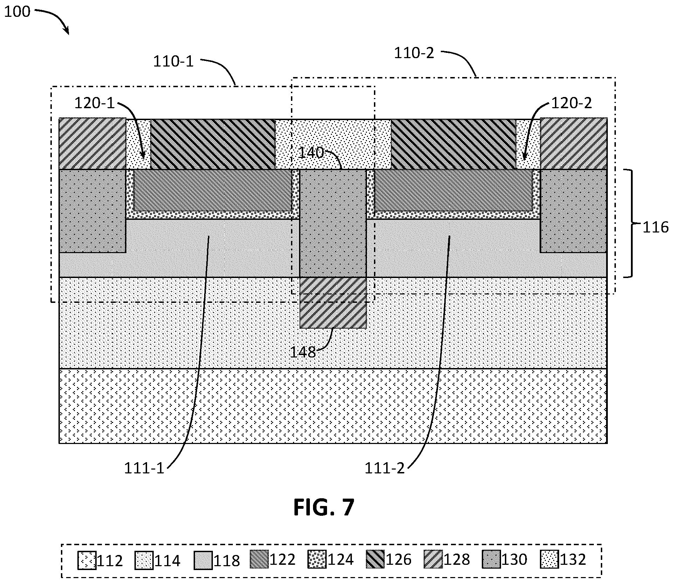

In the IC devices 100 shown in FIG. 5 and FIG. 6, the gate stacks 120 are provided above respective portions of the top surface of the thin-film semiconductor material 118. In such embodiments, the bottoms of the gate stacks 120 may be aligned with the bottoms of the S/D contacts 128 because both the gate stacks 120 and the S/D contacts 128 contact respective portions of the thin-film semiconductor material 118. FIG. 7 illustrates an embodiment of the IC device 100 that is substantially the same as that shown in FIG. 5 (i.e., top-gated TFTs 110, backside shared S/D contact 148), except that the layer 116 is shown to be thicker so that it is easier to illustrate that the gate stacks 120 are recessed into the thin-film semiconductor material 118, which may have advantages as described above. For example, in some embodiments, the tops of the gate stacks 120 may be aligned with the top of the thin-film semiconductor material 118 and with the bottom of the S/D contacts 128, as shown in FIG. 7. However, in other embodiments of the recessed gate stacks 120 with top-gated TFTs 110 and backside shared S/D contact 148, the gate stacks 120 may be only partially recessed into the thin-film semiconductor material 118, i.e., with portions of sidewalls of the gate stacks 120 being in the layer 116, while other portions of sidewalls of the gate stacks 120 being above the layer 116.

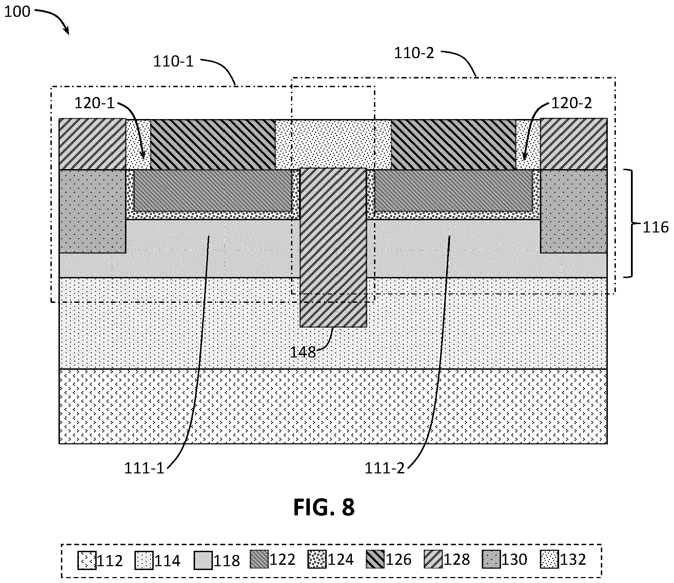

In the IC device 100 shown in FIG. 7, the shared S/D contact 148 contacts a portion of the bottom surface of the thin-film semiconductor material 118. FIG. 8 illustrates an embodiment of the IC device 100 that is substantially the same as that shown in FIG. 7 (i.e., top-gated TFTs 110, backside shared S/D contact 148, recessed gate stacks 120), except that the shared S/D contact 148 extends all through the thin-film semiconductor material 118, away from the support structure 110, which may have advantages as described above. In further embodiments of the top-gated TFTs 110 with backside shared S/D contact 148, the shared S/D contact 148 may extend partially into the thin-film semiconductor material 118, i.e., it may extend above contacting the bottom surface of the thin-film semiconductor material 118 as shown in FIG. 7, but not all the way through the thin-film semiconductor material 118 as shown in FIG. 8.

FIGS. 9-16 provide cross-sectional side views illustrating different examples of IC devices 100 with two bottom-gated TFTs 110-1 and 110-2 with the shared S/D contact 148, according to some embodiments of the present disclosure.

In the IC device 100 shown in FIGS. 1-8, the TFTs 110 were top-gated transistors. FIG. 9 illustrates an embodiment of the IC device 100 that is substantially the same as that shown in FIG. 1 (i.e., front-side shared S/D contact 148), except that the TFTs 110 shown in FIG. 9 are bottom-gated TFTs, since their respective gate stacks 120 are between the support structure 112 and their respective channel regions 111 in the thin-film semiconductor material 118. Having the gate stacks 120 at the bottom of the TFTs 110 may provide the advantage of easier connection of the gate stacks 120 to other IC device components underneath the TFTs 110 (e.g., to the frontend transistors of the IC device 100 or to backside power delivery structures that may be present in the IC device 100). It may also provide the advantage of less crowded space above the TFTs 110.

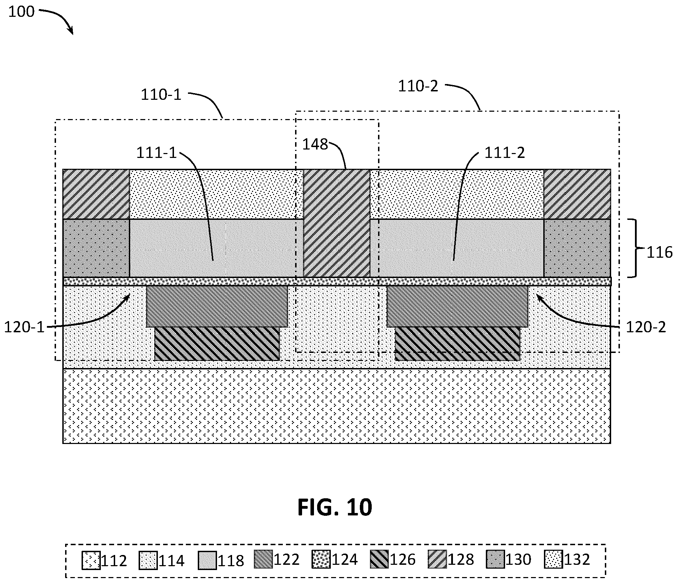

In the IC device 100 shown in FIG. 9, the shared S/D contact 148 contacts a portion of the top surface of the thin-film semiconductor material 118 (i.e., the shared S/D contact 148 is a front-side shared S/D contact 148). FIG. 10 illustrates an embodiment of the IC device 100 that is substantially the same as that shown in FIG. 9 (i.e., bottom-gated TFTs 110, front-side shared S/D contact 148), except that the shared S/D contact 148 extends all through the thin-film semiconductor material 118, towards the support structure 110, which may have advantages as described above. In further embodiments of the bottom-gated TFTs 110 with front-side shared S/D contact 148, the shared S/D contact 148 may extend partially into the thin-film semiconductor material 118, i.e., it may extend below contacting the top surface of the thin-film semiconductor material 118 as shown in FIG. 9, but not all the way through the thin-film semiconductor material 118 as shown in FIG. 10.

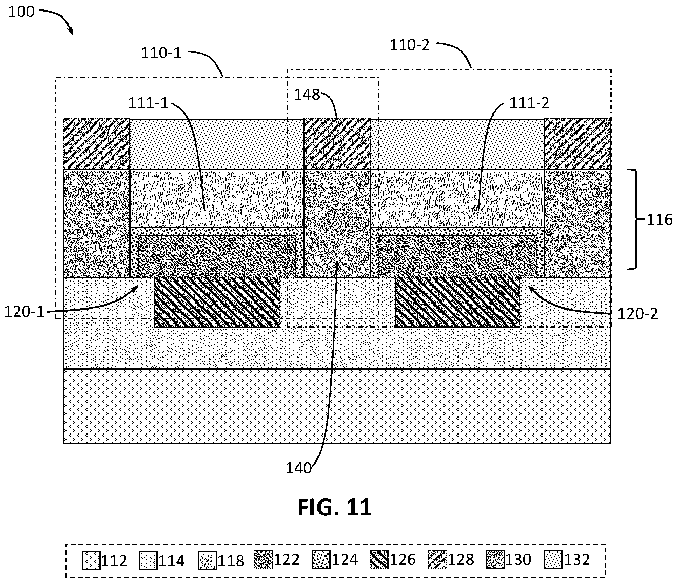

In the IC devices 100 shown in FIG. 9 and FIG. 10, the gate stacks 120 are provided below respective portions of the bottom surface of the thin-film semiconductor material 118. In such embodiments, the bottoms of the gate stacks 120 may be aligned with the bottom of the layer 116. FIG. 11 illustrates an embodiment of the IC device 100 that is substantially the same as that shown in FIG. 9 (i.e., bottom-gated TFTs 110, front-side shared S/D contact 148), except that the layer 116 is shown to be thicker so that it is easier to illustrate that the gate stacks 120 protrude into the thin-film semiconductor material 118. For example, in some embodiments, the bottoms of the gate stacks 120 may be aligned with the bottom of the layer 116, as shown in FIG. 11. However, in other embodiments of the protruded gate stacks 120 with bottom-gated TFTs 110 and front-side shared S/D contact 148, the gate stacks 120 may be only partially protruding into the thin-film semiconductor material 118, i.e., with portions of sidewalls of the gate stacks 120 being in the layer 116, while other portions of sidewalls of the gate stacks 120 being below the layer 116. Protruding the gate stacks 120 of the bottom-gated TFTs 110 into the thin-film semiconductor material 118 may have the advantage of an increased gate length for the same surface area occupied by a gate stack.

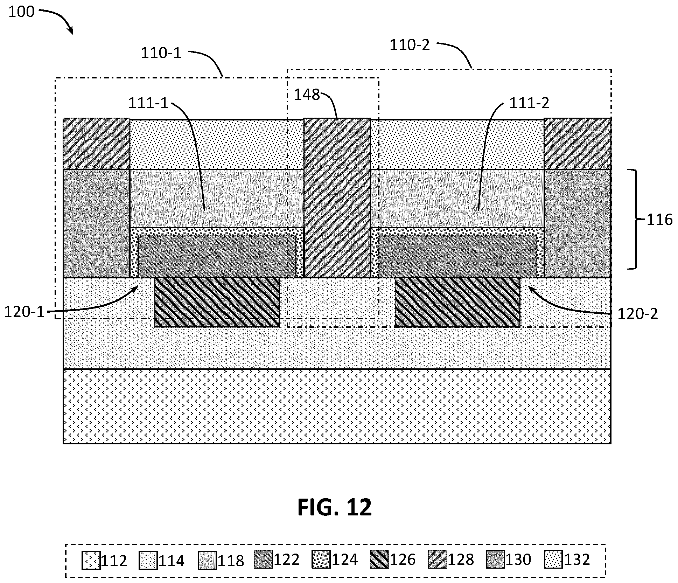

In the IC device 100 shown in FIG. 11, the shared S/D contact 148 contacts a portion of the bottom surface of the thin-film semiconductor material 118. FIG. 12 illustrates an embodiment of the IC device 100 that is substantially the same as that shown in FIG. 11 (i.e., top-gated TFTs 110, front-side shared S/D contact 148, protruded gate stacks 120), except that the shared S/D contact 148 extends all through the thin-film semiconductor material 118, away from the support structure 110, which may have advantages as described above. In further embodiments of the bottom-gated TFTs 110 with front-side shared S/D contact 148 and protruded gate stacks 120, the shared S/D contact 148 may extend partially into the thin-film semiconductor material 118, i.e., it may extend above contacting the bottom surface of the thin-film semiconductor material 118 as shown in FIG. 11, but not all the way through the thin-film semiconductor material 118 as shown in FIG. 12.

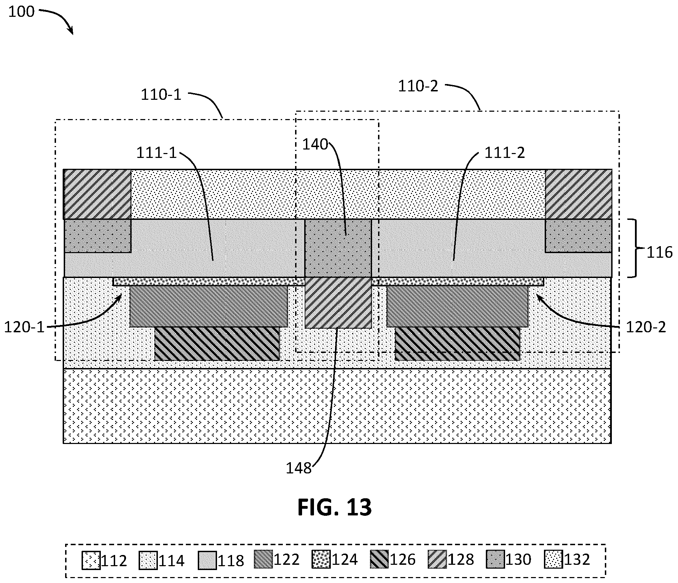

In the IC device 100 shown in FIGS. 9-12, the shared S/D contact 148 is a front-side contact in that it is provided from the top of the layer 116. FIG. 13 illustrates an embodiment of the IC device 100 that is substantially the same as that shown in FIG. 9 (i.e., bottom-gated TFTs 110), except that the shared S/D contact 148 is provided at the bottom of the layer 116 (i.e., the shared S/D contact 148 is a backside shared S/D contact 148), which may have advantages as described above.

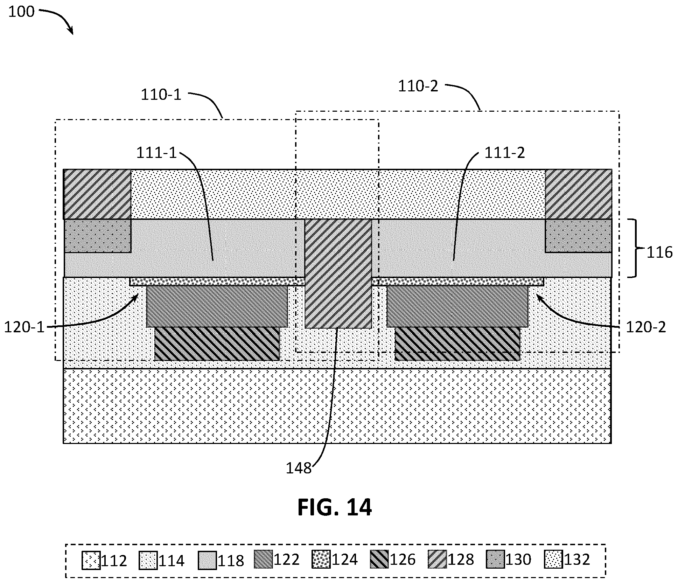

In the IC device 100 shown in FIG. 13, the shared S/D contact 148 contacts a portion of the bottom surface of the thin-film semiconductor material 118. FIG. 14 illustrates an embodiment of the IC device 100 that is substantially the same as that shown in FIG. 13 (i.e., bottom-gated TFTs 110, backside shared S/D contact 148), except that the shared S/D contact 148 extends all through the thin-film semiconductor material 118, from the bottom of the layer 116 and away from the support structure 110, which may have advantages as described above. In further embodiments of the bottom-gated TFTs 110 with backside shared S/D contact 148, the shared S/D contact 148 may extend partially into the thin-film semiconductor material 118, i.e., it may extend above contacting the bottom surface of the thin-film semiconductor material 118 as shown in FIG. 13, but not all the way through the thin-film semiconductor material 118 as shown in FIG. 14.

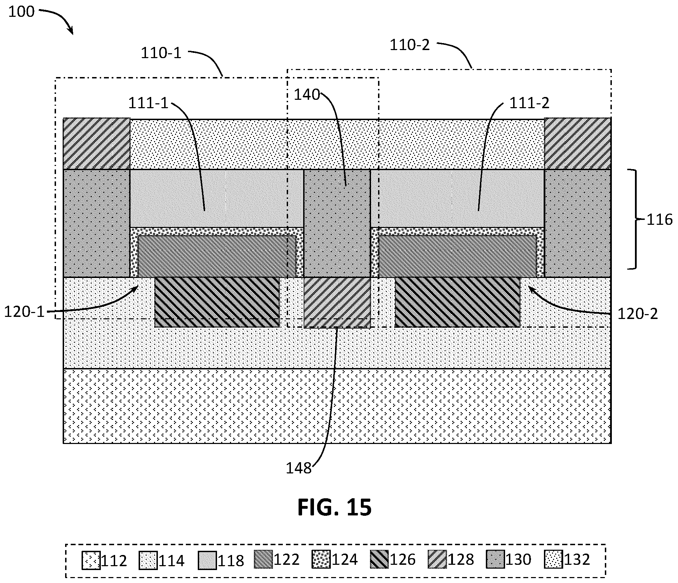

In the IC devices 100 shown in FIG. 13 and FIG. 14, the gate stacks 120 are provided below respective portions of the bottom surface of the thin-film semiconductor material 118. In such embodiments, the bottoms of the gate stacks 120 may be aligned with the bottom of the layer 116. FIG. 15 illustrates an embodiment of the IC device 100 that is substantially the same as that shown in FIG. 13 (i.e., bottom-gated TFTs 110, backside shared S/D contact 148), except that the layer 116 is shown to be thicker so that it is easier to illustrate that the gate stacks 120 are protruded into the thin-film semiconductor material 118, which may have advantages as described above. For example, in some embodiments, the bottoms of the gate stacks 120 may be aligned with the bottom of the layer 116, as shown in FIG. 15. However, in other embodiments of the protruded gate stacks 120 with bottom-gated TFTs 110 and backside shared S/D contact 148, the gate stacks 120 may be only partially protruded into the thin-film semiconductor material 118, i.e., with portions of sidewalls of the gate stacks 120 being in the layer 116, while other portions of sidewalls of the gate stacks 120 being below the layer 116.

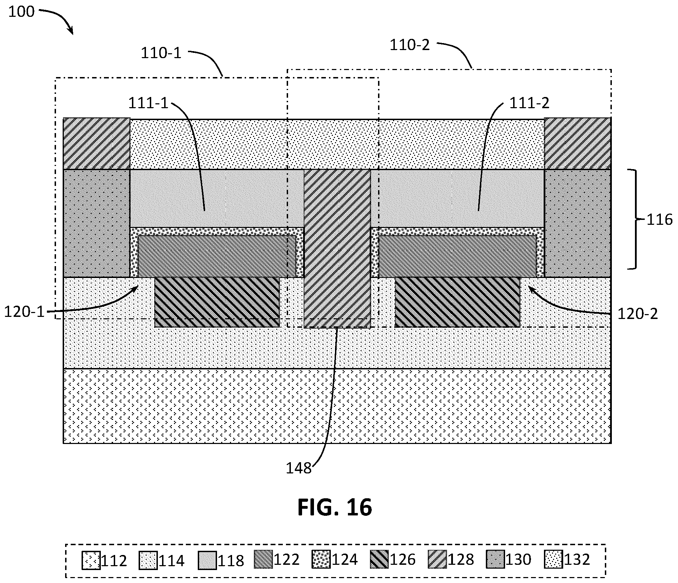

In the IC device 100 shown in FIG. 15, the shared S/D contact 148 contacts a portion of the bottom surface of the thin-film semiconductor material 118. FIG. 16 illustrates an embodiment of the IC device 100 that is substantially the same as that shown in FIG. 15 (i.e., top-gated TFTs 110, backside shared S/D contact 148, protruded gate stacks 120), except that the shared S/D contact 148 extends all through the thin-film semiconductor material 118, away from the support structure 110, which may have advantages as described above. In further embodiments of the bottom-gated TFTs 110 with backside shared S/D contact 148, the shared S/D contact 148 may extend partially into the thin-film semiconductor material 118, i.e., it may extend above contacting the bottom surface of the thin-film semiconductor material 118 as shown in FIG. 15, but not all the way through the thin-film semiconductor material 118 as shown in FIG. 16.

FIGS. 17-18 provide cross-sectional side views illustrating different examples of IC devices 100 with two vertical TFTs 110-1 and 110-2 with a shared gate stack 150, according to some embodiments of the present disclosure. The shared gate stack 150 may include the gate electrode material 122 and the gate dielectric material 124 as described with reference to the gate stack 120, but a different reference numeral is used to indicate that the gate stack 150 is shared between a pair of TFTs 110. The S/D contacts of the first TFT 110-1 are shown in FIG. 17 to the left side of the shared gate stack 150, above and bottom the layer 116, while the S/D contacts of the second TFT 110-2 are shown in FIG. 17 to the right side of the shared gate stack 150, also above and bottom the layer 116.

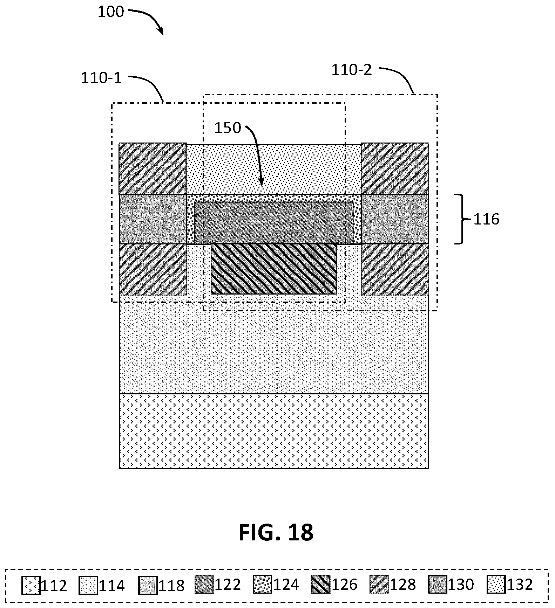

In the IC device 100 shown in FIG. 17, the TFTs 110 may be considered to be top-gated transistors because the gate contact 126 is provided above the shared gate stack 150. FIG. 18 illustrates an embodiment of the IC device 100 that is substantially the same as that shown in FIG. 17 (i.e., vertical TFTs 110 with shared gate stack 150), except that the TFTs 110 shown in FIG. 18 may be considered to be bottom-gated TFTs because the gate contact 126 is provided below the shared gate stack 150.

Various embodiments of the IC devices 100 shown in FIGS. 1-18, described above, do not represent an exhaustive list of the IC devices that may implement TFTs with shared contacts and further embodiments are possible, all of which being within the scope of the present disclosure. For example, in various embodiments, at least portions of the gate stacks 120 may at least partially extend over (for the top-gated TFTs 110) or under (for the bottom-gated TFTs 110) any of the S/D contacts, or may be narrower than the distance between respective source and drain contacts of a TFT 110. In another example, the first and second TFTs 110 with a shared contact do not always have to be symmetric as they are shown in all of FIGS. 1-18. Moreover, in various embodiments, any of the first and second TFTs 110 with a shared contact may be of any of the embodiments described herein, and not necessarily of the same embodiment.

Any suitable techniques may be used to manufacture the IC device 100 implementing TFTs with shared contacts as disclosed herein, e.g., subtractive, additive, damascene, dual damascene, etc. Some of such techniques may include suitable deposition and patterning techniques. As used herein, "patterning" may refer to forming a pattern in one or more materials using any suitable techniques (e.g., applying a resist, patterning the resist using lithography, and then etching the one or more material using dry etching, wet etching, or any appropriate technique).

IC devices implementing pairs of TFTs with shared contacts as disclosed herein may be included in any suitable electronic device. FIGS. 19-23 illustrate various examples of devices and components that may include one or more IC devices implementing pairs of TFTs with shared contacts according to any embodiments disclosed herein.

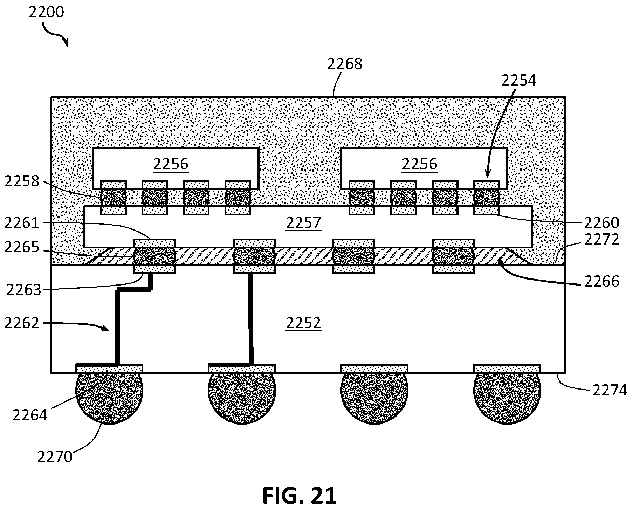

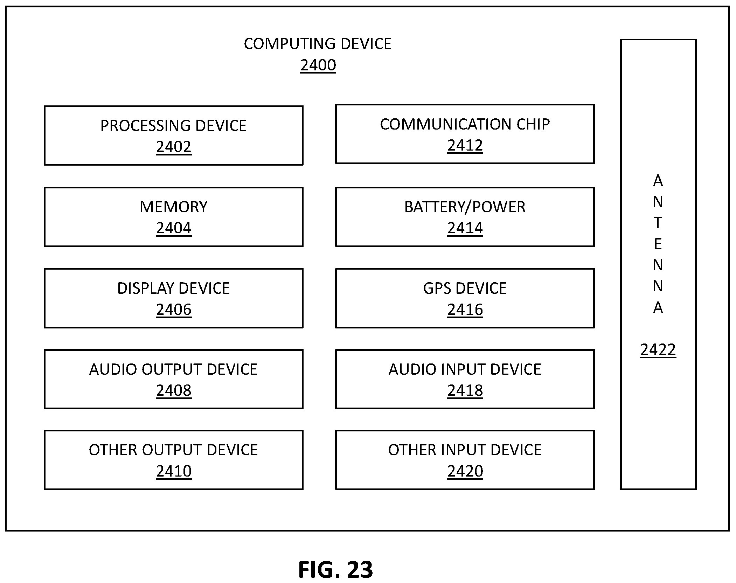

FIGS. 19A-19B are top views of a wafer 2000 and dies 2002 that may include one or more pairs of TFTs with shared contacts in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 21. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more pairs of TFTs with shared contacts as described herein). After the fabrication of the semiconductor product is complete (e.g., after manufacture of one or more IC devices implementing pairs of TFTs with shared contacts as described herein), the wafer 2000 may undergo a singulation process in which each of the dies 2002 is separated from one another to provide discrete "chips" of the semiconductor product. In particular, IC devices that include one or more pairs of TFTs with shared contacts as disclosed herein may take the form of the wafer 2000 (e.g., not singulated) or the form of the die 2002 (e.g., singulated). The die 2002 may include one or more pairs of the TFTs 110 with shared contacts as described herein and/or one or more frontend transistors as described herein, one or more storage elements, and/or supporting circuitry to route electrical signals to the transistors and/or the storage elements, as well as any other IC components. In some embodiments, the wafer 2000 or the die 2002 may implement or include a memory device (e.g., a dynamic random-access memory (DRAM) device), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2402 of FIG. 23) or other logic that is configured to store information in the memory devices or execute instructions stored in the memory array.

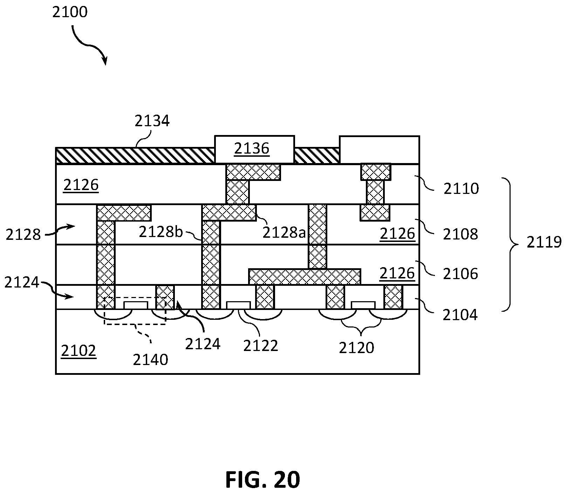

FIG. 20 is a cross-sectional side view of an IC device 2100 that may include one or more pairs of TFTs with shared contacts in accordance with any of the embodiments disclosed herein. For example, the IC device 2100 may be, or may include, the IC device 100, described above, implementing one or more stacked memory arrays 190, one or more of which could include pairs of TFTs with shared contacts according to any embodiments described herein. In particular, the one or more pairs of TFTs with shared contacts as described herein may be implemented in any of the backend layers of the IC device 2100, e.g., in any of the interconnect layers 2106-2110 shown in FIG. 20. Because there are various possibilities where such pairs of TFTs with shared contacts may be integrated in the IC device 2100, the pairs of TFTs with shared contacts are not specifically shown in FIG. 20. In some embodiments, the IC device 2100 may serve as any of the dies 2256 in the IC package 2300.

As shown in FIG. 20, the IC device 2100 may be formed on a substrate 2102 (e.g., the wafer 2000 of FIG. 19A) and may be included in a die (e.g., the die 2002 of FIG. 19B). The substrate 2102 may include any material that may serve as a foundation for an IC device 2100. The substrate 2102 may be a semiconductor substrate, and may be implemented as described above with reference to the support structure 110 shown in FIG. 1. Although a few examples of the substrate 2102 are described here, any material or structure that may serve as a foundation upon which an IC device 2100 may be built falls within the spirit and scope of the present disclosure. The substrate 2102 may be part of a singulated die (e.g., the die 2002 of FIG. 19B) or a wafer (e.g., the wafer 2000 of FIG. 19A).

The IC device 2100 may include one or more device layers 2104 disposed on the substrate 2102. The device layer 2104 may include features of one or more transistors 2140 (e.g., metal-oxide-semiconductor field-effect transistors (MOSFETs)) formed on the substrate 2102. The device layer 2104 may include, for example, one or more S/D regions 2120, a gate 2122 to control current flow in the transistors 2140 between the S/D regions 2120, and one or more S/D contacts 2124 to route electrical signals to/from the S/D regions 2120. The transistors 2140 may include additional features not depicted for the sake of clarity, such as device isolation regions, gate contacts, and the like.

Each transistor 2140 may include a gate 2122 formed of at least two layers, a gate dielectric layer and a gate electrode layer. Generally, the gate dielectric layer of a transistor 2140 may include one layer or a stack of layers, and may include any of the materials described above with reference to the gate dielectric material 124. In some embodiments, an annealing process may be carried out on the gate dielectric of the gate 2122 to improve its quality when a high-k material is used.

The gate electrode may be formed on the gate dielectric and may include at least one P-type work function metal or N-type work function metal, depending on whether the transistor 2140 is to be a PMOS or an NMOS transistor. In some implementations, the gate electrode may include a stack of two or more metal layers, where one or more metal layers are work function metal layers and at least one metal layer is a fill metal layer. Further metal layers may be included for other purposes, such as a barrier layer. The gate electrode of the gate 2122 may include any of the materials described above with reference to the gate electrode material 122.

In some embodiments, when viewed as a cross-section of the transistor 2140 along the source-channel-drain direction, the gate electrode of the gate 2122 may include a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may include a combination of U-shaped structures and planar, non-U-shaped structures. For example, the gate electrode may include one or more U-shaped metal layers formed atop one or more planar, non-U-shaped layers. In some embodiments, the gate electrode may include a V-shaped structure (e.g., when the fin of a FinFET does not have a "flat" upper surface, but instead has a rounded peak).

In some embodiments, a pair of sidewall spacers may be formed on opposing sides of the gate stack to bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2120 may be formed within the substrate 2102, e.g., adjacent to the gate of each transistor 2140. The S/D regions 2120 may be formed using an implantation/diffusion process or an etching/deposition process, for example. In the former process, dopants such as boron, aluminum, antimony, phosphorous, or arsenic may be ion-implanted into the substrate 2102 to form the S/D regions 2120. An annealing process that activates the dopants and causes them to diffuse farther into the substrate 2102 may follow the ion implantation process. In the latter process, the substrate 2102 may first be etched to form recesses at the locations of the S/D regions 2120. An epitaxial deposition process may then be carried out to fill the recesses with material that is used to fabricate the S/D regions 2120. In some implementations, the S/D regions 2120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2120 may be formed using one or more alternate semiconductor materials such as germanium or a group III-V material or alloy. In further embodiments, one or more layers of metal and/or metal alloys may be used to form the S/D regions 2120.

Various transistors 2140 are not limited to the type and configuration depicted in FIG. 20 and may include a wide variety of other types and configurations such as, for example, planar transistors, non-planar transistors (e.g., FinFETs, nanowire, or nanoribbon transistors), or a combination of both.

Electrical signals, such as power and/or input/output (I/O) signals, may be routed to and/or from the transistors 2140 of the device layer 2104 through one or more interconnect layers disposed on the device layer 2104 (illustrated in FIG. 20 as interconnect layers 2106-2110). For example, electrically conductive features of the device layer 2104 (e.g., the gate 2122 and the S/D contacts 2124) may be electrically coupled with the interconnect structures 2128 of the interconnect layers 2106-2110. The one or more interconnect layers 2106-2110 may form an ILD stack 2119 of the IC device 2100.

The interconnect structures 2128 may be arranged within the interconnect layers 2106-1210 to route electrical signals according to a wide variety of designs (in particular, the arrangement is not limited to the particular configuration of interconnect structures 2128 depicted in FIG. 20). Although a particular number of interconnect layers 2106-1210 is depicted in FIG. 20, embodiments of the present disclosure include IC devices having more or fewer interconnect layers than depicted.

In some embodiments, the interconnect structures 2128 may include trench structures 2128a (sometimes referred to as "lines") and/or via structures 2128b (sometimes referred to as "holes") filled with an electrically conductive material such as a metal. The trench structures 2128a may be arranged to route electrical signals in a direction of a plane that is substantially parallel with a surface of the substrate 2102 upon which the device layer 2104 is formed. For example, the trench structures 2128a may route electrical signals in a direction in and out of the page from the perspective of FIG. 20. The via structures 2128b may be arranged to route electrical signals in a direction of a plane that is substantially perpendicular to the surface of the substrate 2102 upon which the device layer 2104 is formed. In some embodiments, the via structures 2128b may electrically couple trench structures 2128a of different interconnect layers 2106-2110 together.

The interconnect layers 2106-2110 may include a dielectric material 2126 disposed between the interconnect structures 2128, as shown in FIG. 20. In some embodiments, the dielectric material 2126 disposed between the interconnect structures 2128 in different ones of the interconnect layers 2106-2110 may have different compositions; in other embodiments, the composition of the dielectric material 2126 between different interconnect layers 2106-2110 may be the same. The dielectric material 2126 may include any of the materials described above with reference to the insulator material of the IC device 100.

A first interconnect layer 2106 (referred to as Metal 1 or "M1") may be formed directly on the device layer 2104. In some embodiments, the first interconnect layer 2106 may include trench structures 2128a and/or via structures 2128b, as shown. The trench structures 2128a of the first interconnect layer 2106 may be coupled with contacts (e.g., the S/D contacts 2124) of the device layer 2104.

A second interconnect layer 2108 (referred to as Metal 2 or "M2") may be formed directly on the first interconnect layer 2106. In some embodiments, the second interconnect layer 2108 may include via structures 2128b to couple the trench structures 2128a of the second interconnect layer 2108 with the trench structures 2128a of the first interconnect layer 2106. Although the trench structures 2128a and the via structures 2128b are structurally delineated with a line within each interconnect layer (e.g., within the second interconnect layer 2108) for the sake of clarity, the trench structures 2128a and the via structures 2128b may be structurally and/or materially contiguous (e.g., simultaneously filled during a dual damascene process) in some embodiments.

A third interconnect layer 2110 (referred to as Metal 3 or "M3") (and additional interconnect layers, as desired) may be formed in succession on the second interconnect layer 2108 according to similar techniques and configurations described in connection with the second interconnect layer 2108 or the first interconnect layer 2106.

The interconnect layers 2106-2110 may be the metal layers M1-M3, described above and shown some of the drawings described above. Further metal layers may be present in the IC device 2100, as also described above.

The IC device 2100 may include a solder resist material 2134 (e.g., polyimide or similar material) and one or more bond pads 2136 formed on the interconnect layers 2106-2110. The bond pads 2136 may be electrically coupled with the interconnect structures 2128 and configured to route the electrical signals of the transistor(s) 2140 to other external devices. For example, solder bonds may be formed on the one or more bond pads 2136 to mechanically and/or electrically couple a chip including the IC device 2100 with another component (e.g., a circuit board). The IC device 2100 may have other alternative configurations to route the electrical signals from the interconnect layers 2106-2110 than depicted in other embodiments. For example, the bond pads 2136 may be replaced by or may further include other analogous features (e.g., posts) that route the electrical signals to external components.

FIG. 21 is a side, cross-sectional view of an example IC package 2200 that may include one or more IC devices implementing pairs of TFTs with shared contacts in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274. These conductive pathways may take the form of any of the interconnect structures 2128 discussed above with reference to FIG. 20.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 21 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 21 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

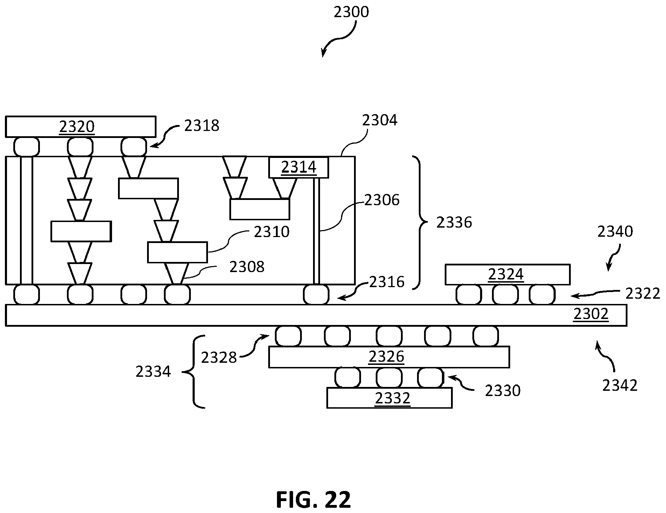

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 21 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 22.

The dies 2256 may take the form of any of the embodiments of the die 2002 discussed herein (e.g., may include any of the embodiments of the IC device 2100). In embodiments in which the IC package 2200 includes multiple dies 2256, the IC package 2200 may be referred to as a multichip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded memory dies implementing pairs of TFTs with shared contacts as described herein. In some embodiments, any of the dies 2256 may include one or more IC devices implementing pairs of TFTs with shared contacts, e.g., as discussed above; in some embodiments, at least some of the dies 2256 may not include any IC devices implementing pairs of TFTs with shared contacts.

The IC package 2200 illustrated in FIG. 21 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 21, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 22 is a cross-sectional side view of an IC device assembly 2300 that may include components having one or more IC devices implementing pairs of TFTs with shared contacts in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC devices implementing pairs of TFTs with shared contacts in accordance with any of the embodiments disclosed herein; e.g., any of the IC packages discussed below with reference to the IC device assembly 2300 may take the form of any of the embodiments of the IC package 2200 discussed above with reference to FIG. 21 (e.g., may include one or more IC devices implementing pairs of TFTs with shared contacts provided on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 22 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 22), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 19B), an IC device (e.g., the IC device 2100 of FIG. 20), or any other suitable component. In particular, the IC package 2320 may include one or more IC devices implementing pairs of TFTs with shared contacts as described herein. Although a single IC package 2320 is shown in FIG. 22, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 22, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as radio frequency (RF) devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 22 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 23 is a block diagram of an example computing device 2400 that may include one or more components with one or more IC devices implementing pairs of TFTs with shared contacts in accordance with any of the embodiments disclosed herein. For example, any suitable ones of the components of the computing device 2400 may include a die (e.g., the die 2002 (FIG. 19B)) including one or more IC devices implementing pairs of TFTs with shared contacts in accordance with any of the embodiments disclosed herein. Any of the components of the computing device 2400 may include an IC device 2100 (FIG. 20) and/or an IC package 2200 (FIG. 21). Any of the components of the computing device 2400 may include an IC device assembly 2300 (FIG. 22).

A number of components are illustrated in FIG. 23 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 23, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402. This memory may be used as cache memory and may include eDRAM, e.g., a stacked TFT based eDRAM as described herein, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

### Select examples

The following paragraphs provide various examples of the embodiments disclosed herein.

Example 1 provides an IC device that includes a support structure (e.g., a substrate, a die, a wafer, or a chip); a channel layer provided over the support structure, the channel layer including a thin-film semiconductor material; a first TFT; and a second TFT, where a channel region of the first TFT includes a first portion of the channel layer, a channel region of the second TFT includes a second portion of the channel layer, and one of a source contact and a drain contact of the first TFT is a shared contact that is also one of a source contact or a drain contact of the second TFT.

Example 2 provides the IC device according to example 1, where the shared contact is in contact with a third portion of the channel layer, a second one of the source contact and the drain contact of the first TFT is in contact with a fourth portion of the channel layer, and a second one of the source contact and the drain contact of the second TFT is in contact with a fifth portion of the channel layer, and where the third portion of the channel layer is between the fourth portion of the channel layer and the fifth portion of the channel layer.

Example 3 provides the IC device according to example 2, where the third portion of the channel layer is between the support structure and the shared contact.

Example 4 provides the IC device according to example 2, where the shared contact is between the support structure and the third portion of the channel layer.

Example 5 provides the IC device according to example 1, where the shared contact replaces a third portion of the channel layer, a second one of the source contact and the drain contact of the first TFT is in contact with a fourth portion of the channel layer, and a second one of the source contact and the drain contact of the second TFT is in contact with a fifth portion of the channel layer, and where the first portion of the channel layer is between the fourth portion of the channel layer and the shared contact, and the second portion of the channel layer is between the fifth portion of the channel layer and the shared contact.

Example 6 provides the IC device according to example 5, where the shared contact extends above the channel layer, away from the support structure.

Example 7 provides the IC device according to example 5, where the shared contact extends below the channel layer, towards the support structure.

Example 8 provides the IC device according to any one of examples 2-7, where the fourth portion of the channel layer is between the support structure and the second one of the source contact and the drain contact of the first TFT.

Example 9 provides the IC device according to any one of examples 2-8, where the fifth portion of the channel layer is between the support structure and the second one of the source contact and the drain contact of the second TFT.

Example 10 provides the IC device according to any one of examples 1-9, where a gate stack of the first TFT is between the support structure and the first portion of the channel layer.

Example 11 provides the IC device according to any one of examples 1-9, where the first portion of the channel layer is between the support structure and a gate stack of the first TFT.

Example 12 provides the IC device according to any one of examples 1-11, where a gate stack of the second TFT is between the support structure and the second portion of the channel layer.

Example 13 provides the IC device according to any one of examples 1-11, where the second portion of the channel layer is between the support structure and a gate stack of the second TFT.

Example 14 provides an IC device that includes a support structure (e.g., a substrate, a die, a wafer, or a chip); a channel layer provided over the support structure, the channel layer including a thin-film semiconductor material; a first TFT; and a second TFT, where a channel region of the first TFT includes a first portion of the channel layer, a channel region of the second TFT includes a second portion of the channel layer, a gate stack of the first TFT is a shared gate stack that is also a gate stack of the second TFT, and the shared gate stack is between the first portion of the channel layer and the second portion of the channel layer.

Example 15 provides the IC device according to example 14, where the first portion of the channel layer is between a source contact and a drain contact of the first TFT.

Example 16 provides the IC device according to examples 14 or 15, where the second portion of the channel layer is between a source contact and a drain contact of the second TFT.

Example 17 provides the IC device according to any one of examples 14-16, where the shared gate stack is between the support structure and a gate contact coupled to the gate stack.

Example 18 provides the IC device according to any one of examples 14-16, where a gate contact coupled to the gate stack is between the support structure and the shared gate stack.

Example 19 provides an IC package that includes an IC device according to any one of the preceding examples; and a further component, coupled to the IC device.

Example 20 provides the IC package according to example 19, where the further component is or includes one of a package substrate, an interposer, or a further IC die.

In various further examples of the IC package according to examples 19 or 20, the further component may be coupled to the IC die via one or more first-level interconnects, where the one or more first-level interconnects may include one or more solder bumps, solder posts, or bond wires.

In further examples of the IC package according to any of the preceding examples, the IC die includes, or is a part of, at least one of a memory device, a computing device, a wearable device, a handheld electronic device, and a wireless communications device.

Example 21 provides an electronic device that includes a carrier substrate; and one or more of the IC device according to any one of the preceding examples and the IC package according to any one of the preceding examples, coupled to the carrier substrate.

Example 22 provides the electronic device according to example 21, where the carrier substrate is a motherboard.

Example 23 provides the electronic device according to example 21, where the carrier substrate is a PCB.

Example 24 provides the electronic device according to any one of examples 21-23, where the electronic device is a wearable electronic device (e.g., a smart watch) or handheld electronic device (e.g., a mobile phone).

Example 25 provides the electronic device according to any one of examples 21-24, where the electronic device further includes one or more communication chips and an antenna.

Example 26 provides the electronic device according to any one of examples 21-25, where the electronic device is a memory device.

Example 27 provides the electronic device according to any one of examples 21-25, where the electronic device is one of an RF transceiver, a switch, a power amplifier, a low-noise amplifier, a filter, a filter bank, a duplexer, an upconverter, or a downconverter of an RF communications device, e.g., of an RF transceiver.

Example 28 provides the electronic device according to any one of examples 21-25, where the electronic device is a computing device.

Example 29 provides the electronic device according to any one of examples 21-28, where the electronic device is included in a base station of a wireless communication system.

Example 30 provides the electronic device according to any one of examples 21-28, where the electronic device is included in a user equipment device (i.e., a mobile device) of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a support structure;
a channel layer over the support structure, the channel layer including a thin-film semiconductor material;
a first thin-film transistor (TFT); and
a second TFT,
wherein:
a channel region of the first TFT includes a first portion of the channel layer,
a channel region of the second TFT includes a second portion of the channel layer, and
one of a source contact and a drain contact of the first TFT is a shared contact that is also one of a source contact or a drain contact of the second TFT.

2. The IC device according to claim 1, wherein the shared contact is in contact with a third portion of the channel layer, a second one of the source contact and the drain contact of the first TFT is in contact with a fourth portion of the channel layer, and a second one of the source contact and the drain contact of the second TFT is in contact with a fifth portion of the channel layer, and wherein the third portion of the channel layer is between the fourth portion of the channel layer and the fifth portion of the channel layer.

3. The IC device according to claim 2, wherein the third portion of the channel layer is between the support structure and the shared contact.

4. The IC device according to claim 2, wherein the shared contact is between the support structure and the third portion of the channel layer.

5. The IC device according to claim 1, wherein the shared contact replaces a third portion of the channel layer, a second one of the source contact and the drain contact of the first TFT is in contact with a fourth portion of the channel layer, and a second one of the source contact and the drain contact of the second TFT is in contact with a fifth portion of the channel layer, and wherein the first portion of the channel layer is between the fourth portion of the channel layer and the shared contact, and the second portion of the channel layer is between the fifth portion of the channel layer and the shared contact.

6. The IC device according to claim 5, wherein the shared contact extends above the channel layer, away from the support structure.

7. The IC device according to claim 5, wherein the shared contact extends below the channel layer, towards the support structure.

8. The IC device according to any one of claims 2-7, wherein the fourth portion of the channel layer is between the support structure and the second one of the source contact and the drain contact of the first TFT.

9. The IC device according to any one of claims 2-8, wherein the fifth portion of the channel layer is between the support structure and the second one of the source contact and the drain contact of the second TFT.

10. The IC device according to any one of claims 1-9, wherein a gate stack of the first TFT is between the support structure and the first portion of the channel layer.

11. The IC device according to any one of claims 1-9, wherein the first portion of the channel layer is between the support structure and a gate stack of the first TFT.

12. The IC device according to any one of claims 1-11, wherein a gate stack of the second TFT is between the support structure and the second portion of the channel layer.

13. The IC device according to any one of claims 1-11, wherein the second portion of the channel layer is between the support structure and a gate stack of the second TFT.

14. An integrated circuit (IC) package, comprising:
an IC die, comprising an IC device according to any one of claims 1-13; and
a further component, coupled to the IC die.

15. The IC package according to claim 14, wherein the further component is one of a package substrate, an interposer, or a further IC die.
